# EUROPEAN PATENT SPECIFICATION

(11) **EP 3 503 389 B1**
(45) Date of publication and mention of the grant of the patent: **13.03.2024**
(21) Application number: 17209770.1
(22) Date of filing: 21.12.2017
(51) Int. Cl.: H03G 1/00, H03F 3/45, H03F 1/48, H03F 3/08, H03F 3/195

(54) **OUTPUT COMMON MODE VOLTAGE REGULATED VARIABLE GAIN AMPLIFIER**
AUSGANGS-GLEICHTAKTSPANNUNGSREGULIERTER VARIABLER GAIN-VERSTÄRKER
AMPLIFICATEUR À GAIN VARIABLE RÉGULÉ PAR TENSION DE MODE COMMUN EN SORTIE

(43) Date of publication of application: 26.06.2019
(73) Proprietor: IHP GmbH - Innovations for High Performance Microelectronics / Leibniz-Institut für innovative Mikroelektronik, 15236 Frankfurt (Oder) (DE)
(72) Inventor: EISSA, Mohamed, 10623 Berlin (DE); KISSINGER, Dietmar, 91054 Buckenhof (DE); KO, Minsu, 15236 Frankfurt (Oder) (DE)
(74) Representative: Eisenführ Speiser

(56) References cited:
- EP-A1- 3 236 585
- US-A- 3 684 974
- US-A- 5 578 964
- US-A1- 2003 085 764
- US-A1- 2003 214 356
- US-B1- 6 316 996

## Description

The present invention relates to a variable gain amplifier for amplifying a differential pair of input voltage signals.

A variable gain amplifier (VGA) is an important building block in integrated direct conversion receivers (homodyne receivers) for wireless and wireline communication systems. In wireless communication systems the RF signal is down-converted to baseband and then amplified via cascaded VGA stages to reach the required full scale voltage swing needed by an analog to digital converter (ADC). In wireline communication systems, such as long-haul fiber optic communication systems, the received optical signal is converted to an electric current through a photo diode (PD). The electric current is then converted to voltage signal via a transimpedance amplifier (TIA), and later amplified by cascaded VGA stages to reach a required voltage swing.

VGAs based on the Gilbert cell are well known. Another commonly used VGA topology comprises a main trans-conductance stage delivering current into a current commuting cascode stage. By controlling the current steered into a load resistance using the control voltages, the gain of the VGA is controlled. This topology shows better performance compared to a Gilbert cell based VGA in terms of bandwidth uniformity across different gain states. It also has a better bandwidth due to lower load capacitance compared to the Gilbert cell based VGA.

US/2003/0214356 A1 describes an amplifier for use as an LNA of a radio frequency tuner, which comprises a differential amplifying stage provided with an automatic gain control (AGC) core. The output signals are formed across load resistors at differential outputs. Compensating stages sum the signals at the differential outputs and subtract the resulting sum signal from the output signals so as to cancel the common mode signals including second order distortion products.

EP3236585A1 discloses a chopper differential amplifier comprising a common mode set circuit used to set the common mode output voltages.

US 3,684,974 discloses is a differential amplifier circuit featuring gain control. In one embodiment, first and second pairs of differentially coupled transistors are connected respectively to first and second differentially coupled input transistors, and the input transistors are connectable to a source of differential input signals. Differential output signals are derived at the outputs of transistors in each of the pairs of transistors, and by applying an automatic gain control (AGC) signal at a node which is common to the transistor pairs, electronic gain control is obtained. In another embodiment, an output differential amplifier stage is directly coupled to transistors in the first and second pairs of transistors so that any common mode signal present there is rejected in said output stage.

A general problem with cascaded VGA stages for amplifying a differential pair of input voltage signals is a direct coupling between the VGA stages, which leads to shared common mode voltage levels. This in turn puts limitations on design parameters of the VGA and leads to suboptimal designs. In some cases, due to the limitations in the common mode voltage levels in between the VGA stages, additional VGA stages are required in direct conversion receivers to achieve the required gain.

An output common mode voltage increases in particular at lower gain states. This effect leads to a degraded linearity at the lower gain states. Furthermore, headroom problems arise across process variations. In addition, the higher output common mode at lower gain states limits the achievable voltage swing which contributes also in having worse linearity.

According to the present invention, a variable gain amplifier for amplifying a differential pair of input voltage signals is defined in claim 1.

The variable gain amplifier of the present invention, hereinafter also referred to in short as VGA, is based on the recognition that conventional approaches to reducing or avoiding common mode voltages raise new problems. In particular, for avoiding problems created by common mode voltages, either the resistive load or a bias current could be increased so as to increase the gain of the VGA, which in turn would lead to a lower output common mode voltage. However, this would add constraints on the design and in the outcome would lead to suboptimal designs. To overcome such limitations, a new VGA design in accordance with claim 1 is proposed.

The VGA of the present invention includes a common-mode bias servo stage that receives a reference voltage of a reference voltage amount and the differential pair of output voltage signals, and that comprises a pair of closed loop differential amplifiers, each configured to generate a respective DC bias voltage of a DC bias voltage amount depending on a difference between the respective output voltage amount and the reference voltage amount, and each feeding the respective generated DC bias voltage back to the respective differential signal output node.

This way, a feedback loop is implemented which acts as a biasing network for the VGA. This regulates the output DC common mode voltage of the VGA. By introducing a closed loop differential amplifier for sensing the DC voltage component of the output voltage and comparing it to a reference voltage, an output of the differential amplifier can be used as a DC bias voltage, which is fed back to the respective differential signal output node. By proper selection of the reference voltage in operation of the VGA, this loop can achieve that a common mode output current through the resistive load is greatly reduced or even fully eliminated, and thus only AC signal components flow through the resistive loads of the VGA.

In the following, embodiments of the variable gain amplifier circuit of the present invention will be described. The additional features of these embodiments can be combined with each other to form further embodiments, unless explicitly specified as forming alternatives.

Suitably, the VGA comprises a VGA supply voltage input for receiving a VGA supply voltage (Vcc2) of a VGA supply voltage amount. The VGA voltage supply input is suitably connected to a voltage supply unit that is in one embodiment arranged on-chip, together with the VGA.

While the voltage supply unit is provided as a part of the VGA in one embodiment, this is not a requirement. In other embodiments, any required supply voltage is received from a separate device that is not a part of the claimed VGA. Rather, in such embodiments, the voltage supply unit forms a part of a circuit environment to which the VGA can be connected for operation in a given application case.

According to the invention, the respective closed loop differential amplifiers each comprise an operational amplifier having a non-inverting input receiving the reference voltage and an inverting input receiving a respective output voltage signal of the output voltage signal pair. The respective operational amplifier is configured to generate and provide a current control signal that depends on a difference between the reference voltage and the output voltage signal. The current control signal is fed to a respective voltage controlled current source.

According to the invention, the reference voltage amount equals the VGA supply voltage amount. This can be achieved by providing the VGA supply voltage (Vcc2) to both the VGA supply voltage input and to the reference voltage input. However, it is also possible to provide the reference voltage from a separate reference voltage supply unit. By using voltage supply circuitry configured to provide the reference voltage with a reference voltage amount that is equal to the supply VGA voltage amount, it can be achieved that the DC current component of the VGA is completely delivered by the voltage controlled current source. Thus, as desired, it is achieved that only the AC signal flows through the VGA resistive load for amplification.

The voltage controlled current source is implemented in some embodiments by a PMOS transistor connected in common source mode between the voltage supply input and the respective signal output node of the differential signal output for providing the DC bias voltage. Other types of voltage-controlled current sources can be used, such as for instance a bipolar pnp transistor instead of the PMOS transistor.

In a similar way as described for the VGA supply voltage input, also the voltage supply input used for operating the voltage controlled current source can be suitably connected to voltage supply circuitry, which in one embodiment comprises an on-chip voltage supply. In some embodiments of the VGA, as will be explained further below, the voltage amounts to be provided via the VGA supply voltage input and via the voltage supply input are different from each other, in order to advantageously achieve an optimum suppression of common mode DC current through the resistive load. In these cases, depending on the received amount of supply voltage or VGA supply voltage, the voltage supply circuitry comprises a suitable voltage conversion circuit in at least one of the voltage-supply branches supplying the VGA.

More specifically, in embodiments using a PMOS transistor for the voltage controlled current source in combination with using a differential load stage consisting of respective resistive loads in the form of resistors in the two parallel half-circuits receiving the supply voltage, the voltage supply circuitry is preferably configured to provide the supply voltage with a supply voltage amount that equals a sum of the VGA supply voltage amount and a minimum voltage amount Vdsat required to keep a the PMOS transistor in saturation. In short, this requirement can be expressed as Vcc1 = Vcc2+ Vdsat, wherein Vcc1 is the supply voltage amount, and Vcc2 is the VGA supply voltage amount. Vdsat depends on technology parameters and a transistor sizing. So the amount of Vdsat can be adapted in the VGA circuit design by suitable selection or dimensioning of the mentioned parameters.

In preferred embodiments, the differential load stage comprises respective resistive loads of an identical load resistance amount in two parallel half-circuits receiving the supply voltage.

In one variant of this kind of embodiments, the differential load stage comprises or consists of identical resistors in each of the two parallel half-circuits, both half-circuits receiving the supply voltage.

In examples comprising respective transimpedance amplifiers in the two half-circuits receiving the supply voltage, the voltage supply circuitry is preferably configured to provide the supply voltage with a supply voltage amount (Vcc1) that equals the VGA supply voltage amount (Vcc2), i.e. Vcc1 = Vcc2. The supply voltage, and thus the VGA supply voltage is to be provided in these embodiments with an amount high enough to keep all transistors in active forward operation.

In one embodiment, a dedicated on-chip reference voltage supply is provided which is configured to provide only the reference voltage only to the common-mode bias servo stage.

In one example, a dedicated on-chip reference voltage supply is provided which is configured to provide the reference voltage only to the common-mode bias servo stage.

The VGA of the present invention can be used in many application context. According to a first exemplary application aspect of the present invention, a direct conversion receiver is provided, comprising
- a radio frequency input unit providing a radio frequency signal to a first amplifier,
- a frequency converter that receives an amplified radio frequency signal from the first amplifier and a local oscillation signal and that is configured to convert the amplified radio frequency signal into a baseband signal, and
- an amplifier stage comprising at least one second variable gain amplifier that receives the base band signal and provides an amplified base band signal, wherein
- the at least one second variable gain amplifier is in accordance with the present invention or one of its embodiments.

In this application example, the variable gain amplifier is an important building block for a wireless communication system. In a homodyne or direct-conversion receiver, the RF signal is down-converted to baseband and then amplified via cascaded VGA stages to reach the required full scale voltage swing needed by an analog to digital converter (ADC).

A second application aspect is formed by a photonic receiver, comprising
- a photodetector unit for receiving a modulated photonic signal and converting it into a modulated electric signal, and
- an amplifier stage comprising at least one variable gain amplifier that receives the modulated electronic signal and is configured to provide an amplified modulated signal, wherein
- the variable gain amplifier is in accordance with the present invention or one of its embodiments.

Long-haul fiber optic communication systems require conversion of a received optical signal to electric current through a photodetector which is then converted to a voltage signal via an amplifier stage comprising cascaded VGA stages to reach the required voltage swing.

In both application contexts, limitations of the prior art on the design parameters of the VGA, leading to suboptimal designs, can be avoided. Also the number of VGA stages can be kept small since there are no limitations in the common mode voltage levels in between the stages.

Further embodiments of the VGA will be described in the following with reference to the enclosed drawings.
Fig. 1 shows an embodiment of a variable gain amplifier according to the invention;
Fig. 2 shows a schematic diagram of a wireless homodyne receiver having a cascade of variable gain amplifiers according to one of the first to third embodiments;
Fig. 3 shows a schematic diagram of a wireless photonics receiver having a cascade of variable gain amplifiers according to one of the first to third embodiments;

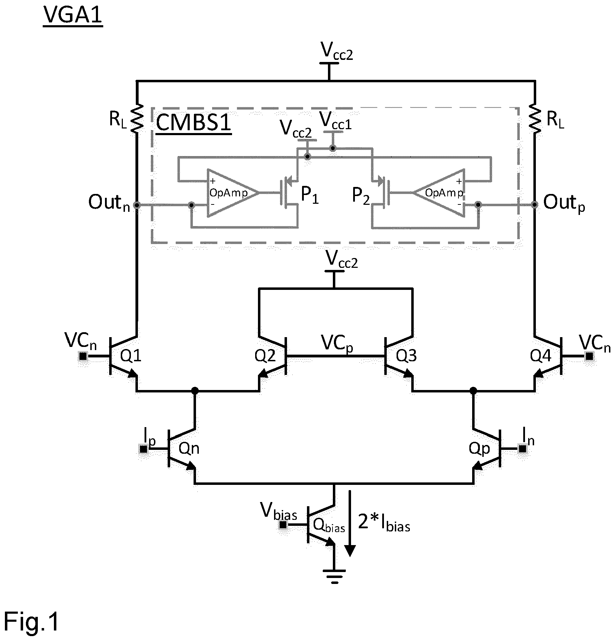

Fig. 1 shows a first embodiment of a variable gain amplifier VGA1. For brevity, the following description will refer to variable gain amplifier VGA1 of Fig. 1 as VGA1 only. For amplifying a differential pair of input voltage signals, VGA1 comprises two half-circuits, each receiving a VGA supply voltage Vcc2 with an identical voltage amount. VGA1 also comprises a VGA supply voltage input for receiving the VGA supply voltage Vcc2. The VGA voltage supply input is connected to a voltage supply unit (not shown) that is suitably, but not necessarily arranged on-chip, together with the VGA.

A respective control input in each half-circuit receives a differential pair of gain control voltage signals VCₚ and VCₙ.

A differential signal input receives an incoming differential pair of input voltage signals Iₚ and Iₙ.

A current commuting stage comprises a cascode stage. The cascode stage comprising transistors Q1 to Q4 has a pair of cascode circuits Q1, Qn and Q2, Qn in a first half-circuit that receives the input voltage signal I_{P}, and a pair of cascode circuits Q3, Qp and Q4, Qp in the second half-circuit that receives the input voltage signal Iₙ. The cascode stage provides a differential pair of current components of respective current amounts that depend on the respective input voltage signal and on the received gain control voltage. The current commuting stage also receives the VGA supply voltage Vcc2.

A trans-conductance stage is formed by the transistors Qn and Qp and delivers current into the current commuting stage. A bias control allowing an application of a bias voltage V_{bias} to a bias control transistor Q_{bias} is connected to the trans-conductance stage. However, it is noted that this bias control is optional and can also be omitted. Another embodiment therefore does not comprise the bias control transistor Q_{bias}, but provides a direct connection to ground potential.

The current components provided by the current commuting stage are provided to a differential load stage that includes respective resistive loads in the form of resistors R_{L} having an identical load resistance amount. The voltage thus generated in each half-circuit by providing the resistors R_{L} with the current components generates a differential pair of output voltage signals Outₙ, Outₚ with respective output voltage amounts that depend on the respective current amounts and on the load resistance amounts. So by controlling the current steered into the load resistance RL using the control voltages VCn and VCp, the gain of VGA1 is controlled.

A common-mode bias servo stage CMBS1 (encircled by a dashed line) receives a reference voltage of a reference voltage amount that in the present embodiment is identical to the VGA supply voltage Vcc2. It also receives the differential pair of output voltage signals Outₙ and Outₚ. The common-mode bias servo stage CMBS1 comprises a pair of closed loop differential amplifiers using operational amplifiers labelled OpAmp in Fig. 1, each being configured to generate a respective DC bias voltage of a DC bias voltage amount depending on a difference between the received respective output voltage amount and the received reference voltage amount (here: Vcc2), and each feeding the respective generated DC bias voltage back to the respective differential signal output node. To provide the DC bias voltage, the output voltage of the respective operational amplifier provides its output as a respective current control signal that is fed to a respective voltage controlled current source. The voltage controlled current source is a PMOS transistor P1, P2 connected in common source mode between a voltage supply input providing a supply voltage Vcc1 and the respective differential signal output node Outₙ, Outₚ of the differential signal output. The supply voltage Vcc1 suitably has a supply voltage amount that equals a sum of the VGA supply voltage amount Vcc2 and a minimum voltage amount Vdsat required to keep the PMOS transistor in saturation. This can be expressed in short as Vcc1= Vcc2 +Vdsat . Vdsat depends on technology parameters and a transistor sizing. So the amount of Vdsat can be adapted in the VGA circuit design by suitable selection or dimensioning of the mentioned parameters.

Thus, the common-mode bias servo stage CMBS1 advantageously provides a feedback loop which acts as a biasing network for the variable gain amplifier VGA1. This regulates an output DC common mode voltage of VGA1 by sensing the DC voltage and comparing it to a reference voltage (here: Vcc2) using the operational amplifiers OpAmp, with the output of the OpAmps controlling the gate of a respective PMOS device P1,P2, which in turn act as a DC current source for the variable gain amplifier VGA1. By setting the reference voltage equal to the supply of VGA1 (namely, Vcc2), this loop achieves that the DC current of VGA1 is delivered by the PMOS device P1, P2 and only the AC signal is to flow through the resistive load R_{L} of VGA1.

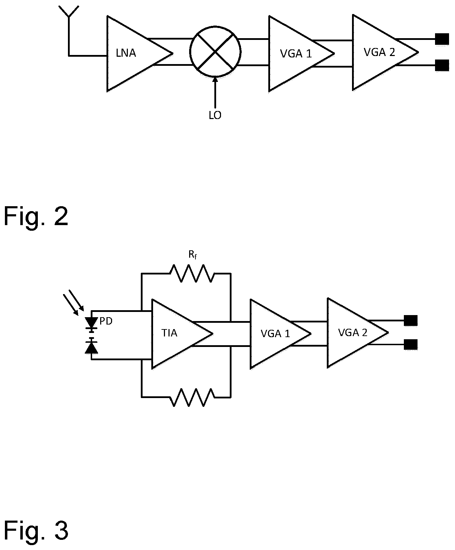

Fig. 2 shows a schematic diagram of a wireless homodyne receiver. The variable gain amplifier (VGA) is an important building block in integrated direct conversion receivers for wireless and wireline communication systems.

The homodyne receiver has a radio frequency input unit such as an antenna for providing a radio frequency signal to a low-noise amplifier LNA. A frequency converter receives an amplified radio frequency signal from the low-noise amplifier LNA and a local oscillation signal LO converts the amplified radio frequency signal into a baseband signal. An amplifier stage comprising two variable gain amplifiers of the type described by the embodiment VGA1 receives the base band signal and provides an amplified base band signal.

Fig. 3 shows a schematic diagram of a wireless photonics receiver having a cascade of variable gain amplifiers according to one of the first to third embodiments. Long-haul fiber optic communication systems require conversion of a received optical signal to electric current through a photodetector which is then converted to a voltage signal via an amplifier stage comprising cascaded VGA stages to reach the required voltage swing. The photonics receiver of Fig. 5 comprises a photodetector unit for receiving a modulated photonic signal and converting it into a modulated electric signal. An amplifier stage comprising at least one variable gain amplifier that receives the modulated electronic signal and is configured to provide an amplified modulated signal by first converting to a voltage signal via a transimpedance amplifier (TIA), which is followed by two variable gain amplifiers in accordance with the present invention or one of its embodiments.

In summary, thus, the solution presented avoids varying DC common mode voltage at different gain stages, and guarantees a fixed input DC common mode voltage for the following stage. It also allows much more flexibility for the design of the VGA gain because the feedback resistance and the bias current can be optimized for gain and linearity independently from the DC levels and bias conditions, which is helpful for optimized designs.

## Claims

1. A variable gain amplifier for amplifying a differential pair of input voltage signals (Ip, In) comprising
- a control input for receiving a differential pair of gain control voltage signals (Vcn, Vcp)
- a differential signal input for receiving the differential pair of input voltage signals (Ip, In)
- a current commuting stage receiving the pair of input voltage signals and the gain control voltage, and comprising a pair of cascode circuits for providing a differential pair of current components of respective current amounts that depend on the respective input voltage signal and on the received gain control voltage;
- a differential load stage receiving the current components and having respective resistive loads (RL) of a respective load resistance amount for generating a differential pair of output voltage signals having respective output voltage amounts that depend on the respective current amounts and on the load resistance amounts; and
- a differential signal output having respective differential signal output nodes for providing the differential pair of output voltage signals (Outn, Outp);
**characterized in that** the variable gain amplifier further comprises
- a common-mode bias servo stage (CMBS1) that receives a reference voltage of a reference voltage amount (Vcc1) and the differential pair of output voltage signals (Outn, Outp) and that comprises a pair of closed loop differential amplifiers, (Opamp) each configured to generate a respective DC bias voltage of a DC bias voltage amount depending on a difference between the respective output voltage amount and the reference voltage amount and wherein each closed loop differential amplifier is configured to feed the respective generated DC bias voltage back to the respective differential signal output node (Outn, Outp)
the variable gain amplifier further comprising voltage supply circuitry for supplying the reference voltage of the reference voltage amount to the pair of closed loop differential amplifiers, and a VGA supply voltage (Vcc2) with an identical voltage amount, such that the reference voltage amount equals a VGA supply voltage amount, and wherein
- the respective closed loop differential amplifiers of the common-mode bias servo stage each comprise an operational amplifier (OpAmp) having a non-inverting input receiving the reference voltage and an inverting input receiving a respective output voltage signal of the output voltage signal pair; and wherein
- the respective operational amplifier (OpAmp) generates and provides a respective current control signal that is fed to a respective voltage controlled current source (P1, P2) that is connected with a voltage supply input to receive a supply voltage ; (Vcc1) and with the respective signal output node (Outp, Outn) of the differential signal output.

2. The variable gain amplifier circuit of claim 1, wherein the voltage controlled current source is a PMOS transistor connected in common source mode between the voltage supply input and the respective differential signal output node of the differential signal output.

3. The variable gain amplifier of at least one of the preceding claims, wherein the differential load stage comprises respective resistive loads of an identical load resistance amount in two half-circuits receiving the supply voltage.

4. A direct conversion receiver comprising
- a radio frequency input unit providing a radio frequency signal to a first amplifier,
- a frequency converter that receives an amplified radio frequency signal from the first amplifier and a local oscillation signal and that is configured to convert the amplified radio frequency signal into a baseband signal, and
- an amplifier stage comprising at least one second variable gain amplifier that receives the base band signal and provides an amplified base band signal, wherein
- the first variable gain amplifier and the at least one second variable gain amplifier is in accordance with at least one of the preceding claims.

5. A photonic receiver comprising
- a photodetector unit for receiving a modulated photonic signal and converting it into a modulated electric signal, and
- an amplifier stage comprising at least one variable gain amplifier that receives the modulated electronic signal and is configured to provide an amplified modulated signal, wherein
- the variable gain amplifier is in accordance with at least one of the claims 1 to 3.

## Patentansprüche

1. Verstärker mit variabler Verstärkung zum Verstärken eines differentiellen Paares von Eingangsspannungssignalen (Ip, In), umfassend
- einen Steuereingang zum Empfang eines differentiellen Paares von Verstärkungssteuerspannungssignalen (Vcn, Vcp);
- einen Differentialsignaleingang zum Empfang des differenziellen Paares von Eingangsspannungssignalen (Ip, In);
- eine Stromkommutierungsstufe, die das Paar von Eingangsspannungssignalen und die Verstärkungssteuerspannung empfängt und die ein Paar von Kaskodenschaltungen umfasst, um ein differentielles Paar von Stromkomponenten mit jeweiligen Strombeträgen bereitzustellen, die von dem jeweiligen Eingangsspannungssignal und von der empfangenen Verstärkungssteuerspannung abhängen;
- eine differentielle Laststufe, die die Stromkomponenten empfängt und jeweilige ohmsche Lasten (RL) mit einem jeweiligen Lastwiderstandswert aufweist, um ein differentielles Paar von Ausgangsspannungssignalen mit jeweiligen Ausgangsspannungsbeträgen zu erzeugen, die von den jeweiligen Strombeträgen und den Lastwiderstandswerten abhängen; und
- einen Differentialsignalausgang mit entsprechenden Differentialsignalausgangsknoten zur Bereitstellung des differenziellen Paares von Ausgangsspannungssignalen (Outn, Outp);
**dadurch gekennzeichnet, dass** der Verstärker mit variabler Verstärkung ferner umfasst
- eine Gleichtaktvorspannungs-Servostufe (CMBS1), die eine Referenzspannung eines Referenzspannungsbetrags (Vcc1) und das differentielle Paar von Ausgangsspannungssignalen (Outn, Outp) empfängt und die ein Paar von Differenzverstärkern mit geschlossener Schleife (OpAmp) umfasst, die jeweils so konfiguriert sind, dass sie eine jeweilige DC-Vorspannung eines DC-Vorspannungsbetrags in Abhängigkeit von einer Differenz zwischen dem jeweiligen Ausgangsspannungsbetrag und dem Referenzspannungsbetrag erzeugen, und wobei jeder Differenzverstärker mit geschlossener Schleife so konfiguriert ist, dass er die jeweilige erzeugte Gleichstromvorspannung zu dem jeweiligen Differentialsignalausgangsknoten (Outn, Outp) zurückführt,
der Verstärker mit variabler Verstärkung ferner umfassend eine Spannungsversorgungsschaltung zum Bereitstellen der Referenzspannung mit dem Referenzspannungsbetrag an das Paar von Differenzverstärkern mit geschlossener Schleife und einer VGA-Versorgungsspannung (Vcc2) mit einem identischen Spannungswert , so dass der Referenzspannungswert gleich einem VGA-Versorgungsspannungswert ist, und wobei
- die jeweiligen Differenzverstärker mit geschlossener Schleife der Gleichtaktvorspannungs-Servostufe jeweils einen Operationsverstärker (OpAmp) mit einem nicht-invertierenden Eingang, der die Referenzspannung empfängt, und einem invertierenden Eingang, der ein jeweiliges Ausgangsspannungssignal des Paares von Ausgangsspannungssignalen empfängt, umfassen; und wobei
- der jeweilige Operationsverstärker (OpAmp) ein jeweiliges Stromsteuersignal erzeugt und bereitstellt, das einer jeweiligen spannungsgesteuerten Stromquelle (P1, P2) zugeführt wird, die mit einem Spannungsversorgungseingang zum Empfang einer Versorgungsspannung (Vcc1) und mit dem jeweiligen Signalausgangsknoten (Outp, Outn) des Differentialsignalausgangs verbunden ist.

2. Verstärkerschaltung mit variabler Verstärkung nach Anspruch 1, wobei die spannungsgesteuerte Stromquelle ein PMOS-Transistor ist, der im Common-Source-Modus zwischen dem Spannungsversorgungseingang und dem jeweiligen Differentialsignalausgangsknoten des Differentialsignalausgangs angeschlossen ist.

3. Verstärker mit variabler Verstärkung nach mindestens einem der vorhergehenden Ansprüche, wobei die differenzielle Laststufe jeweilige Widerstands-Lasten mit identischem Lastwiderstandwert in zwei Halbkreisen aufweist, die die Versorgungsspannung empfangen.

4. Direktumsetzungsempfänger umfassend
- eine Hochfrequenz-Eingangseinheit, die ein Hochfrequenzsignal an einen ersten Verstärker liefert,
- einen Frequenzumsetzer, der ein verstärktes Hochfrequenzsignal vom ersten Verstärker und ein lokales Oszillationssignal empfängt und der konfiguriert ist, das verstärkte Hochfrequenzsignal in ein Basisbandsignal umzusetzen, und
- eine Verstärkerstufe mit mindestens einem zweiten Verstärker mit variabler Verstärkung, der das Basisbandsignal empfängt und ein verstärktes Basisbandsignal bereitstellt, wobei
- der erste Verstärker mit variabler Verstärkung und der mindestens eine zweite Verstärker mit variabler Verstärkung mindestens einem der vorhergehenden Ansprüche entspricht.

5. Photonischer Empfänger, umfassend
- eine Photodetektoreinheit zum Empfangen eines modulierten photonischen Signals und zu dessen Umwandlung in ein moduliertes elektrisches Signal, und
- eine Verstärkerstufe mit mindestens einem Verstärker mit variabler Verstärkung, der das modulierte elektronische Signal empfängt und konfiguriert ist, ein verstärktes moduliertes Signal zu liefern, wobei
- der Verstärker mit variabler Verstärkung mindestens einem der Ansprüche 1 bis 3 entspricht.

## Revendications

1. Amplificateur à gain variable pour amplifier une paire différentielle de signaux de tension d'entrée (Ip, In) comprenant
- une entrée de commande pour recevoir une paire différentielle de signaux de tension de commande de gain (Vcn, Vcp),
- une entrée de signal différentiel pour recevoir la paire différentielle de signaux de tension d'entrée (Ip, In),
- un étage de commutation de courant recevant la paire de signaux de tension d'entrée et la tension de commande de gain, et comprenant une paire de circuits cascode pour fournir une paire différentielle de composantes de courant de quantités de courant respectives qui dépendent du signal de tension d'entrée respectif et de la tension de commande de gain reçue ;
- un étage de charge différentielle recevant les composantes de courant et présentant des résistances respectives de charge (R1) d'une quantité de résistance de charge respective pour générer une paire différentielle de signaux de tension de sortie ayant des quantités de tension de sortie respectives qui dépendent des quantités de courant respectives et des quantités de résistance de charge ; et
- une sortie de signal différentiel ayant des noeuds de sortie de signal différentiel respectifs pour fournir la paire différentielle de signaux de tension de sortie (Outn, Outp) ;
**caractérisé en ce que** l'amplificateur à gain variable comprend en outre
- un étage d'asservissement de polarisation en mode commun (CMBS1) qui reçoit une tension de référence d'une quantité de tension de référence (Vcc1) et la paire différentielle de signaux de tension de sortie (Outn, Outp) et qui comprend une paire de amplificateurs différentiels en boucle fermée (Opamp), chacun configuré pour générer une tension de polarisation CC respective d'une quantité de tension de polarisation CC en fonction d'une différence entre la quantité de tension de sortie respective et la quantité de tension de référence et dans lequel chaque amplificateur différentiel en boucle fermée est configuré pour alimenter la tension de polarisation CC générée respective de retour vers le noeud de sortie de signal différentiel respectif (Outn, Outp)
l'amplificateur à gain variable comprenant en outre un circuit d'alimentation en tension pour fournir la tension de référence de la quantité de tension de référence à la paire d'amplificateurs différentiels en boucle fermée, et une tension d'alimentation VGA (Vcc2) avec une quantité de tension identique, de telle sorte que la quantité de tension de référence est égale à une quantité de tension d'alimentation VGA, et dans lequel
- les amplificateurs différentiels en boucle fermée respectifs de l'étage d'asservissement de polarisation en mode commun comprennent chacun un amplificateur opérationnel (OpAmp) ayant une entrée non inverseuse recevant la tension de référence et une entrée inverseuse recevant un signal de tension de sortie respectif de la paire de signaux de tension de sortie ; et dans lequel
- l'amplificateur opérationnel respectif (OpAmp) génère et fournit un signal de commande de courant respectif qui est envoyé à une source de courant commandée en tension respective (P1, P2) qui est connectée à une entrée d'alimentation en tension pour recevoir une tension d'alimentation (Vcc1) et avec le noeud de sortie de signal respectif (Outp, Outn) de la sortie du signal différentiel.

2. Circuit amplificateur à gain variable selon la revendication 1, dans lequel la source du courant commandé en tension est un transistor PMOS connecté en mode source commune entre l'entrée d'alimentation en tension et le noeud de sortie de signal différentiel respectif de la sortie de signal différentiel.

3. Amplificateur à gain variable selon au moins l'une des revendications précédentes, dans lequel l'étage de charge différentielle comprend des charges résistives respectives d'une valeur de résistance de charge identique dans deux demi-circuits recevant la tension d'alimentation.

4. Récepteur à conversion directe comprenant
- une unité d'entrée radiofréquence fournissant un signal radiofréquence à un premier amplificateur,
- un convertisseur de fréquence qui reçoit un signal radiofréquence amplifié du premier amplificateur et un signal d'oscillation locale et qui est configuré pour convertir le signal radiofréquence amplifié en un signal en bande de base, et
- un étage amplificateur comprenant au moins un deuxième amplificateur à gain variable qui reçoit le signal en bande de base et fournit un signal en bande de base amplifié, dans lequel le premier amplificateur à gain variable et le au moins un deuxième amplificateur à gain variable sont conformes à au moins l'une des revendications précédentes.

5. Récepteur photonique comprenant
- une unité photodétecteur pour recevoir un signal photonique modulé et le convertir en un signal électrique modulé, et
- un étage amplificateur comprenant au moins un amplificateur à gain variable qui reçoit le signal électronique modulé et est configuré pour fournir un signal modulé amplifié, dans lequel
- l'amplificateur à gain variable est conforme à au moins l'une des revendications 1 à 3.
